# EUROPEAN PATENT APPLICATION

(11) **EP 4 604 378 A1**
(43) Date of publication of application: **20.08.2025**
(21) Application number: 24157309.6
(22) Date of filing: 13.02.2024
(51) Int. Cl.: H02M 3/155, H02M 1/32, H02M 1/00

(54) **METHODS OF CONTROLLING A SUPPLY OF ELECTRICAL POWER AND ELECTRICAL SYSTEMS**

(71) Applicant: Thermo King LLC, Minneapolis, MN 55420 (US)
(72) Inventor: GORSKI, Matthias, 44866 Bochum (DE); AUGENSTEIN, Eckardt, 45147 Essen (DE); WANG, Xiaorui, 55435 Edina (US)
(74) Representative: Haseltine Lake Kempner LLP

(57) **Abstract**

The present disclosure relates to method 300 of controlling a supply of electrical power from a DC link 210 to a load 260 using a switching system 250 including a switchable current path 201 between the DC link 210 and the load 260, the switchable current path 201 comprising a controllable switch T1, the method 300 comprising performing a transition procedure 310, 320 including: transitioning 312, 316, 322, 326 the switchable current path 201 between a non-conducting state and a conducting state by progressively varying a duty cycle of a control signal for the switch T1 between 0% and a value equal to or less than 100% inclusive.

## Description

### FIELD OF THE INVENTION

The present disclosure relates to methods of controlling a supply of electrical power from a DC source (e.g., a DC link) to a load. The present disclosure also relates to electrical systems comprising means adapted to carry out such methods.

### BACKGROUND OF THE INVENTION

It is known that coupling of relatively large loads (e.g., a heater) to a power supply can lead to relatively high transient current flows, which may be referred to as inrush currents. Such inrush currents may stress electrical components through which they pass and thus reduce a longer-term reliability of an electrical system of which the electrical components form a part. The present invention has been devised with the foregoing in mind.

### SUMMARY OF THE INVENTION

According to a first aspect there is provided a method of controlling a supply of electrical power from a DC link to a load using a switching system including a switchable current path between the DC link and the load, the switchable current path comprising a controllable switch, the method comprising performing a transition procedure including: transitioning the switchable current path between a non-conducting state and a conducting state by progressively varying a duty cycle of a control signal for the switch between 0% and a value equal to or less than 100% inclusive.

It may be that the transition procedure includes: transitioning the switchable current path between the non-conducting state and the conducting state by progressively varying the duty cycle of the control signal for the switch between 0% and 100% inclusive. It may be that progressively varying a duty cycle of a control signal for the controllable switch between 0% and 100% inclusive includes progressively varying the duty cycle of the control signal for the switch through a range extending from 1% to 99%. It may be that the control signal comprises a pulse-width modulated signal. It may be that the switch is a semiconductor-based switch. The switch may be an insulated-gate bipolar transistor.

The switching system may further comprise a snubber coupled in parallel with the switchable current path between the DC link and the load. The snubber may comprise (e.g., be) a capacitor.

It may be that the method includes: transitioning the switchable current path from the non-conducting state to the conducting state by progressively increasing the duty cycle of the control signal for the switch from 0% to 100% inclusive.

It may be that progressively increasing the duty cycle of the control signal for the controllable switch from 0% to 100% inclusive includes progressively increasing the duty cycle of the control signal for the switch through a range extending from 1% to 99%.

It may be that the method includes: transitioning the primary switchable current path from the conducting state to the non-conducting state by progressively decreasing the duty cycle of the control signal for the switch from 100% to 0% inclusive.

It may be that progressively decreasing the duty cycle of the control signal for the controllable switch from 100% to 0% inclusive includes progressively decreasing the duty cycle of the control signal for the switch through a range extending from 1% to 99%.

The switchable current path may be a primary switchable current path. The switching system may comprise a secondary switchable current path coupled in parallel with the primary switchable current path. The transition procedure may include: maintaining the primary switchable current path in a conducting state while transitioning the secondary switchable current path between a non-conducting state and a conducting-state.

The method may comprise performing a switch-on transition procedure including: maintaining the primary switchable current path in the conducting state while transitioning the secondary switchable current path from the non-conducting state to the conducting-state; and subsequently maintaining the secondary switchable current path in the conducting state while transitioning the primary switchable current path from the conducting state to a non-conducting state.

The method may comprise performing a switch-off transition procedure including: maintaining the primary switchable current path in the conducting state while transitioning the secondary switchable current path from the conducting state to the non-conducting-state; and subsequently maintaining the secondary switchable current path in the non-conducting state while transitioning the primary switchable current path from the conducting state to a non-conducting state.

The secondary switchable current path may comprise a contactor. The method may comprise transitioning the secondary switchable current path between the non-conducting state and the conducting-state by closing or opening the contactor.

The method may comprise receiving, at the switching system from the DC link, an input voltage of at least 600 VDC. The method may comprise receiving, at the switching system from the DC link, an input voltage of at least 700 VDC.

The method may comprise performing the transition procedure in response to a demand to vary a power consumption of the load.

The method may comprise performing the or each transition procedure in response to a demand to vary the power consumption of the load from a first non-zero value to a second non-zero value.

According to a second aspect there is provided an electrical system comprising a DC link, a load, a controller and a switching system including a switchable current path between the DC link and the load, wherein the controller is configured to perform a method in accordance with the first aspect.

It may be that the switchable current path is a primary switchable current path and the switching system includes and a secondary switchable current path coupled in parallel with the primary switchable current path. The load may be a heating arrangement comprising one or more heating elements.

According to a third aspect there is provided a computer program comprising instructions to cause an electrical system in accordance with the first aspect to execute a method in accordance with the first aspect.

According to a fourth aspect there is provided a computer-readable medium having stored thereon a computer program in accordance with the third aspect.

According to a fifth aspect there is provided a transport refrigeration system comprising an electrical system in accordance with the second aspect.

### BRIEF DESCRIPTION OF THE DRAWINGS

**FIG. 1** shows a vehicle comprising a transport refrigeration system;
**FIG. 2** is a schematic diagram of example transport refrigeration unit suitable for use with the vehicle of FIG. 1, the example transport refrigeration unit comprising an electrical system and a vapour-compression refrigeration circuit;
**FIG. 3** is a circuit diagram which shows an example electrical system suitable for use with the transport refrigeration unit of FIG. 2;
**FIG. 4** is a flowchart which shows an example method of controlling a supply of electrical power from a DC link to a load; and
**FIG. 5** is a flowchart which shows a switch-on transition procedure of the method shown by FIG. 4;
**FIG. 6** is a flowchart which shows a switch-off transition procedure of the method shown by FIG. 4;
**FIG. 7** is a highly schematic diagram of a machine-readable medium.

### DETAILED DESCRIPTION OF THE INVENTION

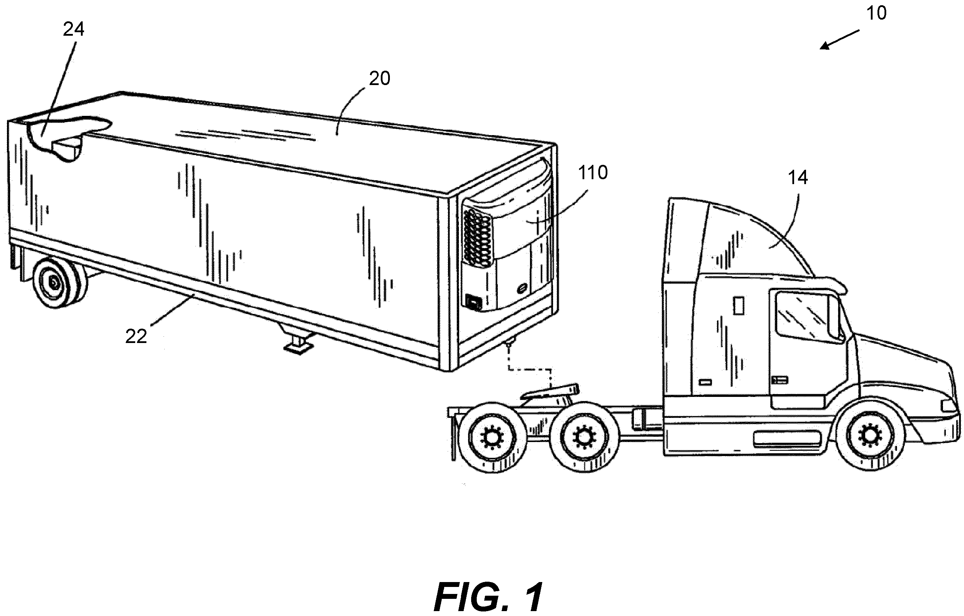

**FIG. 1** shows a vehicle 10 comprising a transport refrigeration system 20. In the example of FIG. 1, the transport refrigeration system 20 forms a part of an over-the-road refrigerated semi-trailer having a structure 22 supporting (or forming) at least one climate-controlled compartment 24 which is configured to be cooled and/or heated by a TRU 110. The climate-controlled compartment 24 can take the form of multiple compartments or have multiple zones. The structure 22 includes a chassis. The structure 22 supports the TRU 110. The vehicle 10 further comprises a tractor unit 14 removably couplable to the trailer.

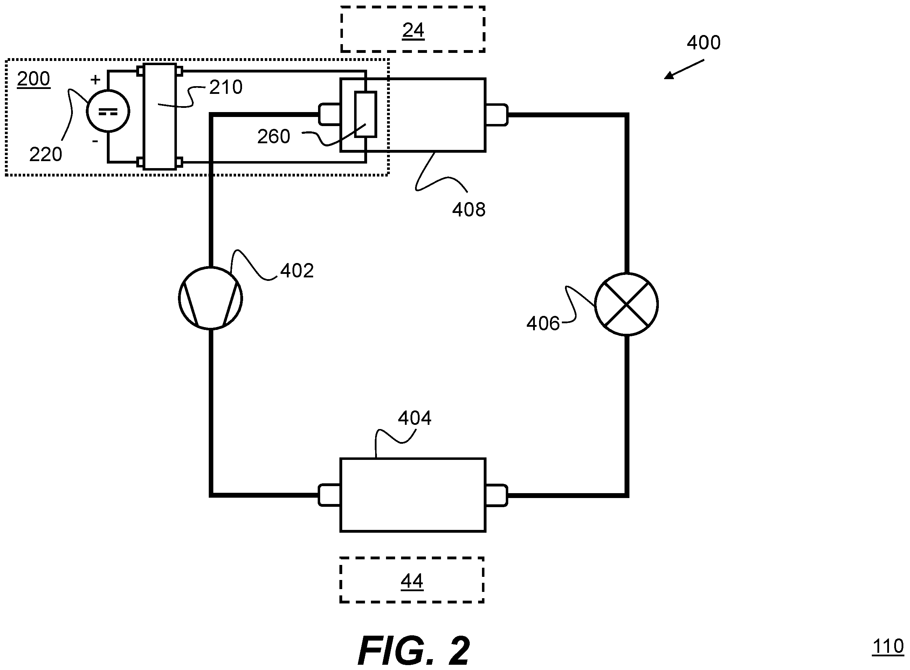

**FIG. 2** schematically shows a diagram of an example TRU 110 suitable for use within the vehicle 10 and the transport refrigeration system 20 of FIG. 1. The TRU 110 comprises a vapour-compression refrigeration circuit 400 and an electrical system 200.

The vapour-compression refrigeration circuit 400 includes an evaporator 408 which is configured to receive heat from the climate-controlled compartment 24 of the transport refrigeration system 20 and a condenser 404 which is configured to reject heat to a thermal sink 44 (e.g., ambient air outside of the climate-controlled compartment 24). For these purposes, the vapour-compression refrigeration circuit 400 also includes a compressor 402 and an expansion valve 406. Accordingly, the vapour-compression refrigeration circuit 400 may be controlled to cause heat to be removed from the climate-controlled compartment 24.

The electrical system 200 comprises a DC link 210 configured to receive electrical power from a DC power supply 220, and a heating arrangement 260 (e.g., a heater 260). This disclosure envisages that the DC power supply 210 may not form part of the electrical system 200 as such, and that the DC link 210 may instead be couplable to, and hence configured to receive electrical power from, a DC power supply 220. It will be appreciated that the term "DC link" is a term of the art, and the DC link may comprise, for instance, an energy storage device such as a DC link capacitor. The DC power supply 220 may be derived from, for instance, a feed-in converter such as an on-board charger (OBC) of the TRU 11 or the vehicle 10.

In the example of Figure 2, the heating arrangement 260 is provided proximal to the evaporator 408. Accordingly, in use, the heating arrangement 260 may be operated to provide heating to the evaporator 408 (e.g., for defrosting the evaporator 408). However, this disclosure envisages that the heating arrangement 260 may be provided elsewhere within the TRU 110. In general terms, the heating arrangement 260 is configured to provide electrical heating to the TRU 110. The electrical system 200 is configured to control a supply of electrical power from the DC link 210 to the heating arrangement 260 and thereby cause the heating arrangement 260 to generate heat for heating the TRU 110. The heating arrangement 260 generates heat by means of resistive (e.g., Ohmic) heating when electrical power is supplied thereto.

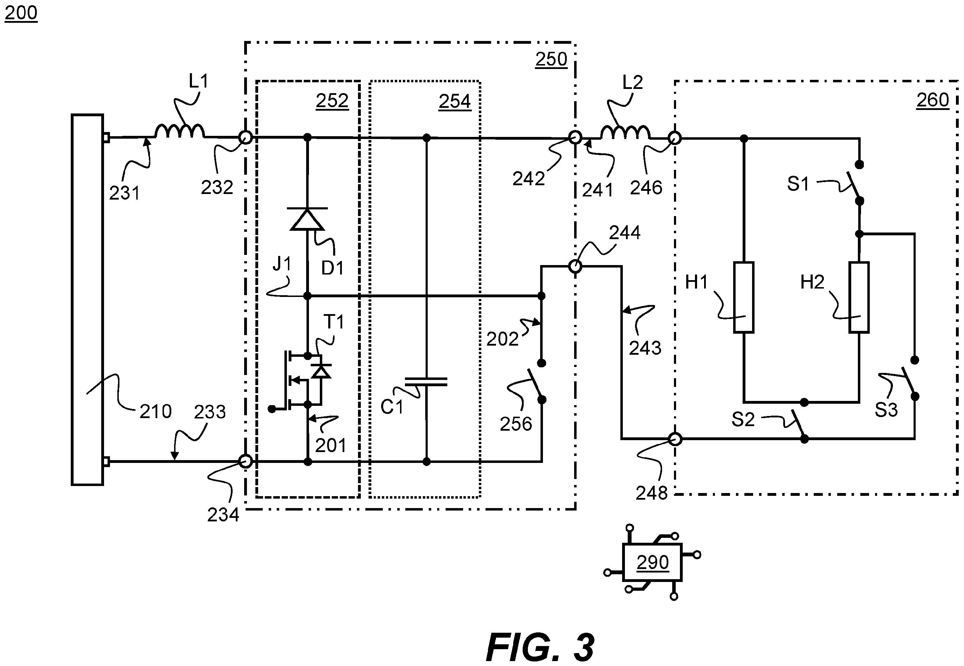

**FIG. 3** is a circuit diagram showing an example electrical system 200 suitable for use as the electrical system 200 of the TRU 110 described above with reference to FIG. 2, with like reference signs denoting similar or common features.

The electrical system 200 comprises a switching system 250. In turn, the switching system 250 includes a half-bridge 252, a snubber 254 and a contactor 256. The switching system 250 is configured to receive electrical power from the DC link 210 through input terminals 232, 234 and to provide electrical power from output terminals 242, 244. The heating arrangement 260 is configured to receive electrical power from the switching system 250 through input terminals 246, 248. In use, the input terminals 232, 234 of the switching system 250 may receive an input voltage of at least 600 VDC, and optionally between 600 VDC and 800 VDC (e.g., 700 VDC) from the DC link 210.

A first input connection rail 231 extends between the DC link 210 and the first input terminal 232 of the switching system 250. Similarly, a second input connection rail 233 extends between the DC link 210 and the second input terminal 234 of the switching system 250. The input connection rails 231, 233 provide an electrical connection between DC link 210 and the heating arrangement 260 via the switching system 250. In use, the first input connection rail 231 is connected to a positive terminal of the DC power supply 220 via the DC link 210 whereas the second input connection rail 233 is connected to a reference voltage (e.g. ground or negative) terminal of the DC power supply 220 via the DC link 210. As a result, an electric potential of the first input connection rail 231 is higher than an electric potential of the second input connection rail 233 during use. Therefore, the first connection rail 231 may be referred to as a positive input connection rail 231 and the second input connection rail 233 may be referred to as a negative input connection rail 233.

Similarly, a first output connection rail 241 extends between the first output terminal 242 of the switching system 250 and the first input terminal 246 of the heating arrangement 260. Similarly, a second output connection rail 243 extends between the second output terminal 244 of the switching system 250 and the second input terminal 248 of the heating arrangement 260. The output connection rails 241, 243 provide an electrical connection between the switching system 250 and the heating arrangement 260. In use, the first output connection rail 241 is connected to the positive terminal of the DC power supply 220 via the DC link 210 and the switching system 250 whereas the second input connection rail 243 is connected to a reference voltage (e.g., ground or negative) terminal of the DC power supply 220 via the DC link 210 and the switching system 250. As a result, an electric potential of the first output connection rail 241 is higher than an electric potential of the second output connection rail 243 during use. Therefore, the first output connection rail 241 may be referred to as a positive output connection rail 241 and the second output connection rail 243 may be referred to as a negative output connection rail 243.

The half-bridge 252 comprises a semiconductor switch T1 (e.g., a controllable semiconductor based switch such as an insulated-gate bipolar transistor) and a diode D1. The semiconductor switch T1 and the diode D1 are coupled in series between the input connection rails 231, 234. A cathode of the diode D1 is coupled to the positive output connection rail 241 via the first output terminal 242 while an anode of the diode is coupled to a half-bridge junction J1 at a node between the diode D1 and the semiconductor switch T1. The semiconductor switch T1 is coupled between the half-bridge junction J1 and the negative input connection rail 233 via the second input terminal 234. Those skilled in the art will appreciate that the diode D1 of the half-bridge 252 may be replaced with a switch (e.g., a further semiconductor switch) as in a conventional half-bridge topology. The half-bridge junction J1 is, in turn, coupled to the negative output connection rail 243 via the second output terminal 244. Therefore, the semiconductor switch T1 forms part of (e.g., functionally provides) a switchable current path 201 between the second input terminal 234 and the second output terminal 244 via the half-bridge junction J1.

The contactor 256 is also coupled between the second input terminal 234 and the second output terminal 244, but not via the half-bridge junction J1. That is, the contactor 256 forms part of (e.g., functionally provides) a switchable current path 202 between the second input terminal 234 and the second output terminal 244 that bypasses the half-bridge junction J1. The switchable current path 202 functionally provided by the semiconductor switch T1 may be referred to as a primary switchable current path 201 herein, whereas the switchable current path 202 functionally provided by the contactor 256 may be referred to as a secondary switchable current path 202 herein.

Therefore, each switchable current path 201, 202 (partially) extends between the DC link 210 and the heating arrangement 260. The primary switchable current path 201 is in parallel with the secondary switchable current path 202.

The snubber 254 comprises a capacitor C1 coupled in series between the positive input connection terminal 232and the negative input terminal 234. A first terminal of the capacitor C1 is coupled to the positive input connection rail 231 via the first input terminal 232 while a second terminal of the capacitor C2 is coupled to the negative input connection rail 233 via the second input terminal 234. The snubber 254 is thus coupled in parallel between the DC link 210 and the heating arrangement 260. Those skilled in the art will appreciate that a snubber may typically comprise a component having a resistance (e.g., a dedicated resistor). However, in electrical systems in accordance with the present disclosure, the snubber 254 need not necessarily comprise a dedicated resistor. Instead, a resistance of the heating arrangement 260 may serve a corresponding purpose.

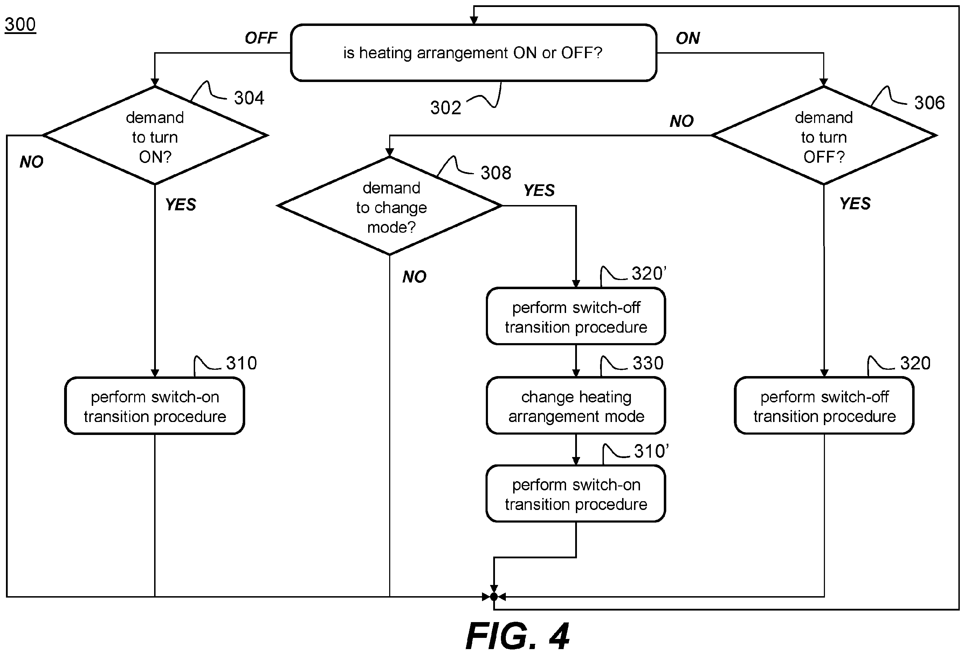

An inductance of the input connection rails 231, 233 is represented in FIG. 3 by a first inductor L1, while an inductance of the output connection rails 241, 243 is represented in FIG. 3 by a second inductor L2. The snubber 254 is advantageously able to suppress voltage fluctuations (e.g., overvoltages) which may arise due to the inductance(s) L1, L2 during performance of the transition procedure(s) described below with reference to FIGs 4 to 6 (e.g., the method 300 described below). In addition, the action of the snubber 254 in use during performance of said transition procedure(s) may reduce an amount of electromagnetic compatibility (EMC) shielding necessary or desirable to allow the electrical system 200 to be readily incorporated within, for example, a transport refrigeration system 20.

Those skilled in the art will also recognise that, by varying a duty cycle of a control signal for the semiconductor switch T1 when the contactor 256 is open, an output voltage supplied to the input terminals 246, 248 of the heating arrangement 260 may be varied between a value which is substantially the same as the input voltage supplied to the input terminals 232, 234 of the switching system 250 from the DC link 210 (i.e., when the duty cycle of the control signal for the switch T1 is 100%) and a value which is approximately/close to zero (i.e., when the duty cycle of the control signal for the switch T1 approximately/close to 0%). For example, when the duty cycle of the control signal for the switch T1 is 50%, the output voltage supplied to the input terminals 246, 248 of the heating arrangement 260 will be approximately half the input voltage supplied to the input terminals 232, 234 of the switching system 250 from the DC link 210. In this way, the half-bridge 252 functions as a buck converter (a step-down converter) in cooperation with the other features of the electrical system 200.

The heating arrangement 260 comprises a first heating element H1 and a second heating element H2. Each heating element has a resistance (for the purpose of providing resistive heating), but may also have a capacitance and/or an inductance. The heating arrangement 260 further comprises a first switch S1, a second switch S2, and a third switch S3. The heating arrangement 260 as a whole may be considered to be a load and/or the individual heating elements H1, H2 may be considered to be loads. In this example, each heating element has substantially the same resistance, which may be, for example, 98 Ohms. Each heating element H1, H2 may have a positive temperature coefficient (PTC) type resistance.

The switches S1, S2, S3 are controllable to change a mode of operation of the heating arrangement 260 and thereby vary a power consumption of the heating arrangement 260. That is, in a low-power mode of the heating arrangement 260, switch S3 is in a closed state (i.e., a conducting state) while both switches S1 and S2 are in an open state (i.e., a non-conducting state). As a result, the heating elements H1, H2 are coupled in series with one another between the input terminals 246, 248 of the heating arrangement 260. Accordingly, an effective overall resistance of the heating arrangement 260 may be 196 Ohms. In an intermediate-power mode of the heating arrangement 260, both switches S1 and S3 are in the open state while switch S2 is in the closed state. Hence only the first heating element H1 is coupled between the input terminals 246, 248 of the heating arrangement 260. Thus the effective overall resistance of the heating arrangement is 98 Ohms. In a high-power mode of the heating arrangement 260, both switches S1 and S2 are in the closed state while switch S3 is in the open state. Therefore, the heating elements H1, H2 are coupled in parallel with one another between the input terminals 246, 248 of the heating arrangement 260. It follows that the effective overall resistance of the heating arrangement is 49 Ohms. Without wishing to be bound by theory, those skilled in the art will appreciate that with a lower effective overall resistance of the heating arrangement 260, an amount of energy lost as heat due to resistive heating in the heating arrangement 260 increases in accordance with Ohm's law and the definition of electric power. Specifically, if the potential difference between the input terminals 246, 248 of the heating arrangement is 700 VDC, then the power consumption, P, of the heating arrangement 260 is as follows: in the low-power mode, P = V²/R = 700²/196= 2.5 kW; in the intermediate-power mode, P = 700²/98= 5 kW; and in the high-power mode, P = 700²/49 =10 kW.

The electrical system 200 further comprises a controller 290 configured to control both the secondary switchable current path 202 (e.g., by controlling the contactor 256) and the primary switchable current path 201 (e.g., by controlling the semiconductor switch T1). The controller 290 may also be configured to vary the power consumption of the heating arrangement 260 (e.g., move between the low-power mode, the intermediate-power mode and the high-power mode thereof).

**FIG. 4** is a flowchart showing an example method 300 of controlling a supply of electrical power from a DC link to a load (e.g., using the electrical system 200, and in particular the switching system 250, described above with reference to FIGs. 2 and 3) in accordance with the present disclosure. The method(s) described herein may be carried out by a suitable data processing apparatus, such as the controller 290 described above with respect to FIG. 3. In other words, the controller 290 may be configured to carry out the method(s) described herein (e.g., the method 300). Although description of the method 300 continues with direct reference to the specific example electrical system 200 described above with reference to FIG. 3, it will be appreciated that the method 300 is more broadly applicable for use with switching systems including a primary switchable current path between a DC link (e.g., the DC link 210) and a load (e.g., the heating arrangement 260) and a secondary switchable current path coupled in parallel with the primary switchable current path.

The method 300 includes determining, at block 302, whether the heating arrangement 260 is on (i.e., is generating heat) or off (i.e., is not generating heat). In other words, the heating arrangement 260 is on when electrical power is being supplied to it from the DC link 210 and is off when electrical power is not being supplied to it from the DC link 210. More specifically, the heating arrangement 260 is off when both the secondary switchable current path 202 and the primary switchable current path 201 are in a non-conducting state (e.g., a fully deactivated state/is fully deactivated). Hence if both the secondary switchable current path 202 and the primary switchable current path 201 are in the non-conducting state, a determination may be made, at block 302, that the heating arrangement 260 is off. On the other hand, if the secondary switchable current path 202 is in a conducting state (e.g., a fully activated state/is fully activated), a determination may be made, at block 302, that the heating arrangement 260 is on. The determination at block 302 may also be based on additional considerations, such as whether the DC link 210 is supplying electrical power to the input terminals 232, 234 of the switching system 250. If so, the electrical system 200 may be provided with appropriate sensor apparatus (e.g., transducers) communicatively coupled to the controller 290 for determining whether electrical power is being supplied to the input terminals 232, 234.

If a determination is made, at block 302, that the heating arrangement 260 is currently off, the method 300 proceeds to determining, at block 304, whether there is a demand to turn the heating arrangement 260 on. The determination at block 304 may include determining whether a demand to turn the heating arrangement 260 on has been received from, for instance, a human-machine interface (HMI) such as a graphical user interface (GUI), or an external data processing apparatus (such as a controller of the TRU 110) via an application-program interface (API). Otherwise, the controller 290 carrying out the method 300 may otherwise determine whether there is a demand to turn the heating arrangement on (e.g., due to frost build-up on the evaporator 408).

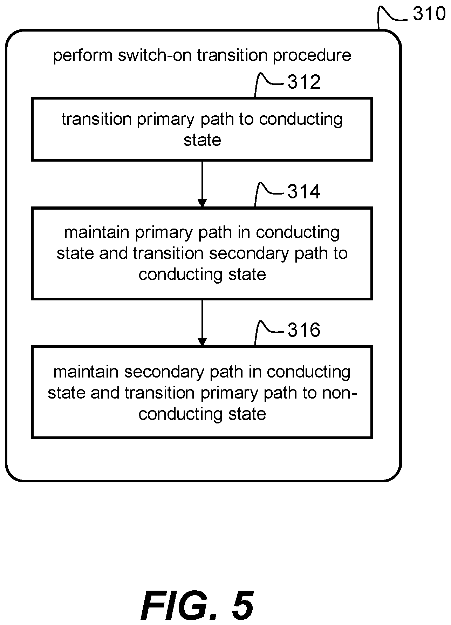

If a determination is made, at block 304, that there is a demand to turn the heating arrangement 260 on, the method continues to performing, at block 310, a switch-on transition procedure using the switching arrangement 250. The switch-on transition procedure is described in further detail below with reference to FIG. 5. However, after the switch-on transition procedure has been performed at block 310, the heating arrangement 260 is switched on and the method 300 returns to the determining, at block 302, whether the heating arrangement 260 is on or off and continues thereafter as described herein. Conversely, if a determination is made, at block 304, that there is not a demand to turn the heating arrangement 260 on, the method 300 directly returns to determining, at block 302, whether the heating arrangement 260 is on or off and continues thereafter.

In the alternative, if a determination is made, at block 302, that the heating arrangement 260 is currently on, the method 300 proceeds to determining, at block 306, whether there is a demand to turn the heating arrangement 260 off. In a similar way to the determination at block 304, the determination at block 306 may include determining whether a demand to turn the heating arrangement 260 off has been received from, for instance, a human-machine interface (HMI) such as a graphical user interface (GUI), or an external data processing apparatus (such as a controller of the TRU 110) via an application-program interface (API). Otherwise, the controller 290 carrying out the method 300 may otherwise determine whether there is a demand to turn the heating arrangement off (e.g., due to clearance of frost from the evaporator 408).

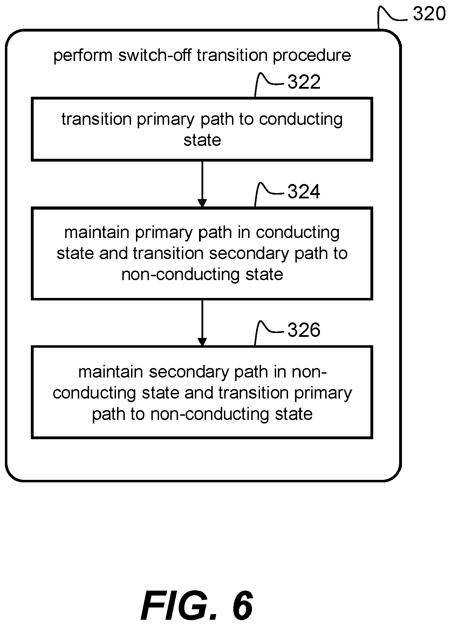

If a determination is made, at block 306, that there is a demand to turn the heating arrangement 260 off, the method continues to performing, at block 320, a switch-off transition procedure using the switching arrangement 250. The switch-off transition procedure is described in further detail below with reference to FIG. 6. However, after the switch-off transition procedure has been performed at block 320, the heating arrangement 260 is switched off and the method 300 returns to determining, at block 302, whether the heating arrangement 260 is on or off and continues thereafter as described herein.

Contrastingly, if a determination is made, at block 306, that there is not a demand to turn the heating arrangement 260 off, the method 300 continues to determining, at block 308, there is a demand to change a mode (e.g., vary a power consumption) of the heating arrangement 260. The determination at block 308 may include determining whether a demand to change the mode of heating arrangement 260 off has been received from, for instance, a human-machine interface (HMI) such as a graphical user interface (GUI), or an external data processing apparatus (such as a controller of the TRU 110) via an application-program interface (API). Otherwise, the controller 290 carrying out the method 300 may otherwise determine whether there is a demand to change the mode of the heating arrangement 260 (e.g., due to excessive heat generation or insufficient heat generation by the heating arrangement 260).

If it is determined, at block 308, that there is not a demand to change the mode of the heating arrangement 260, the method 300 directly returns to determining, at block 302, whether the heating arrangement 260 is on or off and continues thereafter as described herein. If it determined, at block 308, that there is a demand to change the mode of the heating arrangement 260, the method 300 proceeds to: performing, at block 320', a switch-off transition procedure; changing, at block 330, the mode of the heating arrangement 260; and then performing, at block 310', a switch-on transition procedure. The switch-off transition procedure represented by block 320' is generally similar (e.g., identical to) to the switch-off procedure represented by block 320, and the switch-on transition procedure represented by block 310' is generally similar (e.g., identical to) to the switch-off procedure represented by block 310. Changing the mode of the heating arrangement 260, as represented by block 300, may include operating the switches S1, S2, S3 of the heating arrangement 260 in order to move the heating arrangement 260 between the low-power mode, the intermediate-power mode and the high-power mode as described above.

**FIG. 5** is a flowchart showing the switch-on transition procedure as represented by block 310 in FIG. 4. When the switch-on transition procedure is commenced, both the secondary switchable current path 202 and the primary switchable current path 201 are in the non-conducting state. The switch-on transition procedure includes transitioning, at block 312, the primary switchable current path 201 from the non-conducting state to the conducting state. This is achieved by progressively increasing a duty cycle of a pulse-with modulated control signal for the semiconductor switch T1 from 0% to 100% inclusive. As a result, the output voltage supplied to the input terminals 246, 248 of the heating arrangement 260 is progressively increased from approximately zero to the input voltage from the DC link 210. The progressive increase of the duty cycle for the control signal for the semiconductor switch T1 may be determined based on/adapted to the characteristics of the heating arrangement 260 (e.g., if the heating elements H1, H2 have PTC type resistances, the progressive increase of the heating arrangement 260 may be adapted to account for the resistance of the heating elements H1, H2 generally increasing with time).

After the primary switchable current path 201 has been transitioned to the conducting state as described above, the switch-on transition procedure includes maintaining, at block 314, the primary switchable current path 201 in the conducting state while simultaneously transitioning the secondary switchable current path 202 from the non-conducting state into the conducting state. This is achieved by maintaining the duty cycle of the pulse-with modulated control signal for the semiconductor switch T1 at 100% while simultaneously closing the contactor 256.

Once the primary switchable path 201 has been transitioned into the conducting state at block 314, the switch-on transition procedure includes maintaining, at block 316, the secondary switchable current path 202 in the conducting state while transitioning the primary switchable current path 201 from the conducting state into the non-conducting state This is achieved by keeping the contactor 256 closed while decreasing (e.g., progressively decreasing) the duty cycle of the pulse-with modulated control signal for the semiconductor switch T1 from 100% to 0% inclusive.

Following block 316, the switch-on transition procedure is complete and the method 300 continues as described above with reference to FIG. 4. At this stage, the heating arrangement 260 may receive electrical power from the DC link 210 via the secondary switchable current path 202 but not via the primary switchable current path 201.

The switch-on transition procedure, as represented by block 310, provides that the contactor 256 of the secondary switchable current path 202 does not conduct all of the current associated with coupling the heating arrangement 260 to the DC link 210. Instead, the primary switchable current path 201 is operated so as to progressively increase the voltage applied to the heating arrangement 260 before the contactor 256 is closed and begins to conduct current. This limits a magnitude of an inrush current associated with the application of a voltage to the heating elements H1, H2 of the heating arrangement 260 during coupling to the DC link 210. Because inrush currents are associated with stress (e.g., thermal stress) on components such as the heating elements H1, H2, the switch-on transition procedure reduces electrical stress on the heating arrangement 260 and thereby increases a robustness of the electrical system 200 as a whole. Further, because the primary switchable current path 201 conducts some of the current supplied from the DC link 210 as the contactor 256 is closed, a risk to the contactor arising from electrical arcing and/or transient effects as it is closed is mitigated by performance of the switch-on transition procedure, thereby extending a lifetime of the contactor 256. In other words, the contactor 256 does not bear a significant electrical load as it is closed.

**FIG. 6** is a flowchart showing the switch-off transition procedure as represented by block 320 in FIG. 4. When the switch-off transition procedure is commenced, the secondary switchable current path 202 is in the conducting state whereas the primary switchable current path 201 is in the non-conducting state. The switch-off transition procedure includes transitioning, at block 322, the primary switchable current path 201 from the non-conducting state to the conducting state. In a similar way to the switch-on transition procedure, this is achieved by increasing (e.g., progressively increasing) a duty cycle of a pulse-with modulated control signal for the semiconductor switch T1 from 0% to 100%. However, unlike in the switch-on transition procedure, this does not result in the output voltage supplied to the input terminals 246, 248 of the heating arrangement 260 being varied.

After the primary switchable current path 201 has been transitioned to the conducting state as described above, the switch-off transition procedure includes maintaining, at block 324, the primary switchable current path 201 in the conducting state while simultaneously transitioning the secondary switchable current path 202 from the conducting state into the non-conducting state. This is achieved by maintaining the duty cycle of the pulse-with modulated control signal for the semiconductor switch T1 at 100% while simultaneously opening the contactor 256.

Once the primary switchable path 201 has been transitioned into the non-conducting state at block 324, the switch-off transition procedure includes maintaining, at block 326, the secondary switchable current path 202 in the non-conducting state while transitioning the primary switchable current path 201 from the conducting state into the non-conducting state. This is achieved by keeping the contactor 256 open while progressively decreasing the duty cycle of the pulse-with modulated control signal for the semiconductor switch T1 from 0% to 100%.

Following block 326, the switch-off transition procedure is complete and the method 300 continues as described above with reference to FIG. 4. At this stage, the heating arrangement 260 may not receive electrical power from the DC link 210 via the secondary switchable current path 202 or the primary switchable current path 201.

The switch-off transition procedure, as represented by block 320, enables a lifetime of the contactor 256 to be relatively extended as a consequence of the primary switchable current path 201 conducting some of the current supplied from the DC link 210 as the contactor 256 is opened. Therefore, a risk to the contactor 256 arising from electrical arcing and/or transient effects as it is opened is mitigated by performance of the switch-off transition procedure. That is to say that the contactor 256 does not bear a significant electrical load as it is opened.

The transition procedures described herein (i.e., the switch-on transition procedure and the switch-off transition procedure) provide effect and simple means for coupling of relatively large loads to a power supply. In addition, the transition procedures provide that the semiconductor switch T1 of the primary switchable current path 201 need not be continually switched between states while the heating arrangement 260 is on, thereby increasing a mean time between failures (MTBF) of the semiconductor switch T1. This is also associated with an increased efficiency of the conduction of electrical power from the DC link 210 to the heating arrangement 260. Further, this is associated with a relatively reduced peak temperature of the semiconductor switch T1 in use. Consequently, a level of cooling (e.g., a size of a heat sink) provided to the semiconductor switch T1 may be relatively reduced. This facilitates a simpler and/or less complex electrical system 200. Yet further, this is associated with an increased electromagnetic compatibility (EMC) of the electrical system 200.

Moreover, the use of two parallel switchable current paths (i.e., the secondary switchable current path 202 and the primary switchable current path 201) results in a layer of redundancy for the electrical system 200. Namely, if the semiconductor switch T1 fails, the heating arrangement 260 may still be switched on and off by simply opening and closing of the contactor 256 (even though this is generally undesirable for the reasons given above).

Although it has been described, with reference to FIGs. 3 to 6, that the electrical system 200 comprises both a primary switchable current path 201 and a secondary switchable current path 202 and that the method 300 includes taking actions in respect of both switchable current paths 201, 202, this need not necessarily be the case. In particular, it may be that the electrical system 200 only comprises the primary switchable current path 201 comprising the controllable switch T1 (which may then be more simply referred to as the switchable current path 201) and that the method 300 only includes taking actions in respect of said switchable current path 201. If so, it may be that the switch-on transition procedure only comprises transitioning the primary switchable current path 201 from the non-conducting state to the conducting state and subsequently maintaining the primary switchable current path 201 in the conducting state. Conversely, it may be that the switch-on transition procedure only comprises includes transitioning the primary switchable current path 201 from the conducting state to the non-conducting state and subsequently maintaining the primary switchable current path 201 in the non-conducting state.

Further, although it has been described that the method 300 comprises an action of determining, at block 302, whether the heating arrangement 260 is on (i.e., is generating heat) or off (i.e., is not generating heat), this need not necessarily be the case. If so, it may be that if a determination is made, at block 304, that there is not a demand to turn the heating arrangement 260 on, the method 300 proceeds to determining, at block 306, whether there is a demand to turn the heating arrangement 260 off and continues thereafter as described herein. Further, if it is determined, at block 308, that there is not a demand to change the mode of the heating arrangement 260, the method 300 directly returns to determining, at block 304, whether there is a demand to turn the heating arrangement 260 on. Similarly, after the transition procedure(s) has/have been performed at block(s) 310, 310', 320, the method 300 may return to determining at block 304, whether there is a demand to turn the heating arrangement 260 on.

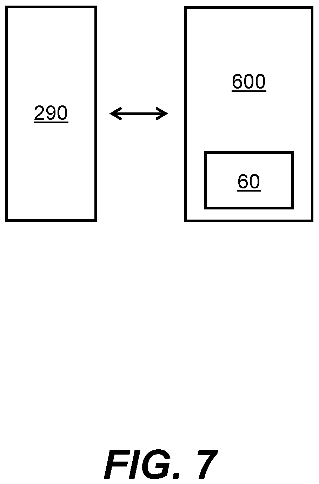

**FIG. 7** shows, highly schematically, a machine-readable medium 600 having stored thereon a computer program 60 comprising instructions which, when executed by the controller 290 provided to a switching system 250 in accordance with the present disclosure (e.g., the switching system 250 of the electrical system 200 described above with reference to FIG. 3), cause the controller 290 to execute the method 300 described above with reference to FIGs. 4-7.

Except where mutually exclusive, a feature described in relation to any one of the above aspects may be applied mutatis mutandis to any other aspect. Furthermore, except where mutually exclusive, any feature described herein may be applied to any aspect and/or combined with any other feature described herein. Moreover, while the present disclosure is made with in the context of transport refrigeration systems and/or vapour-compression circuits, it will be appreciated that the present disclosure has other possible applications in other technical areas.

## Claims

1. A method (300) of controlling a supply of electrical power from a DC link (210) to a load (260) using a switching system (250) including a switchable current path (201) between the DC link and the load, the switchable current path (201) comprising a controllable switch (T1), the method comprising performing a transition procedure (310, 320) including:
transitioning (312, 316, 322, 326) the switchable current path between a non-conducting state and a conducting state by progressively varying a duty cycle of a control signal for the switch between 0% and a value equal to or less than 100% inclusive.

2. The method (300) of claim 1, wherein the switching system (250) further comprises a snubber (254) coupled in parallel between the DC link (210) and the load (260).

3. The method (300) of any preceding claim, including:
transitioning (312, 316, 322, 326) the switchable current path between the non-conducting state and the conducting state by progressively varying the duty cycle of the control signal for the switch between 0% and 100% inclusive.

4. The method (300) of any preceding claim, including:
transitioning (312, 322) the switchable current path from the non-conducting state to the conducting state by progressively increasing the duty cycle of the control signal for the switch from 0% to 100% inclusive.

5. The method (300) of any preceding claim, including:
transitioning (316, 326) the switchable current path from the conducting state to the non-conducting state by progressively decreasing the duty cycle of the control signal for the switch from 100% to 0% inclusive.

6. The method of any preceding claim, wherein the switchable current path (201) is a primary switchable current path and the switching system comprises a secondary switchable current path (202) coupled in parallel with the primary switchable current path, and wherein the transition procedure includes:
maintaining (314, 324) the primary switchable current path in a conducting state while transitioning the secondary switchable current path between a non-conducting state and a conducting-state.

7. The method (300) of claim 6, comprising performing a switch-on transition procedure (310) including:
maintaining (314) the primary switchable current path (201) in the conducting state while transitioning the secondary switchable current path (202) from the non-conducting state to the conducting-state; and subsequently
maintaining (316) the secondary switchable current path in the conducting state while transitioning the primary switchable current path from the conducting state to a non-conducting state.

8. The method (300) of claim 6 or claim 7, comprising performing a switch-off transition procedure (320) including:
maintaining (324) the primary switchable current path (201) in the conducting state while transitioning the secondary switchable current path (202) from the conducting state to the non-conducting-state; and subsequently
maintaining (326) the secondary switchable current path in the non-conducting state while transitioning the primary switchable current path from the conducting state to a non-conducting state.

9. The method (300) of any of claims 6 to 8, wherein the secondary switchable current path (202) comprises a contactor (256), and wherein the method comprises transitioning (314, 324) the secondary switchable current path between the non-conducting state and the conducting-state by closing or opening the contactor.

10. The method (300) of any preceding claim, wherein the method comprises performing the transition procedure in response to a demand (304, 306, 308) to vary a power consumption of the load (260).

11. The method (300) of any preceding claim, wherein the load (260) is a heating arrangement comprising one or more heating elements (H1, H2).

12. An electrical system (200) comprising a DC link (210), a load (260), a controller (290) and a switching system (250) including a switchable current path (201) between the DC link and the load, wherein the controller is configured to perform the method (300) of any preceding claim.

13. A computer program (60) comprising instructions to cause the electrical system (200) of claim 12 to execute the method (300) of any of claims 1 to 11.

14. A computer-readable medium (600) having stored thereon the computer program (60) of claim 13.

15. A transport refrigeration system (20) comprising the electrical system (200) of claim 12.
